# EUROPÄISCHE PATENTANMELDUNG

(11) **EP 4 273 110 A1**
(43) Veröffentlichungstag der Anmeldung: **08.11.2023**
(21) Anmeldenummer: 22171074.2
(22) Anmeldetag: 02.05.2022
(51) Int. Cl.: C04B 28/02, C04B 28/04, C04B 28/06, C04B 28/30, C04B 28/34

(54) **HYDRAULISCH HÄRTBARE ANORGANISCHE ZEMENTZUSAMMENSETZUNG**

(71) Anmelder: Heraeus Deutschland GmbH & Co. KG, 63450 Hanau (DE)
(72) Erfinder: Scheibel, Markus, 63450 Hanau (DE); Albert, Tamara, 63450 Hanau (DE); Pelshaw, Nadja, 63450 Hanau (DE); Roth, Frederik, 63450 Hanau (DE); Schulz, Gerd, 63450 Hanau (DE)
(74) Vertreter: Heraeus IP

(57) **Zusammenfassung**

Hydraulisch härtbare anorganische Zementzusammensetzung umfassend zerkleinerte unbeschichtete Glasfasern aus Alkalioxid-armem oder -freiem Glas und/oder zerkleinerte unbeschichtete Keramikfasern aus Alkalioxid-armer oder -freier Keramik.

## Beschreibung

Die Erfindung betrifft eine hydraulisch härtbare anorganische Zementzusammensetzung, aus der durch Vermischen mit Wasser eine wässrige hydraulisch härtbare anorganische Zementzubereitung hergestellt werden kann. Die wässrige hydraulisch härtbare anorganische Zementzubereitung kann zur Herstellung einer hydraulisch gehärteten anorganischen Zementzusammensetzung insbesondere in Form einer Umhüllung einer elektronischen Komponente verwendet werden.

Der hierin verwendete Begriff "hydraulisches Härten" umfasst ein Abbinden in Gegenwart von Wasser respektive nach Zusatz von Wasser.

Hierin wird unterschieden zwischen hydraulisch härtbarer anorganischer Zementzusammensetzung, wässriger hydraulisch härtbarer anorganischer Zementzubereitung und hydraulisch gehärteter anorganischer Zementzusammensetzung. Aus einer hydraulisch härtbaren anorganischen Zementzusammensetzung kann durch Vermischen mit Wasser eine wässrige hydraulisch härtbare anorganische Zementzubereitung insbesondere in Form einer viskoelastischen, beispielsweise pastösen oder fließfähigen Masse hergestellt werden, auch als "Zementleim (englisch: cement paste oder cement glue)" bezeichnet. Eine wässrige hydraulisch härtbare anorganische Zementzubereitung wiederum kann nach ihrer Applikation hydraulisch zu einer hydraulisch gehärteten anorganischen Zementzusammensetzung in Form eines harten Festkörpers aushärten und trocknen. Besagter harter Festkörper wird auch als "Zementstein (englisch: cement stone)" bezeichnet. Eine derartige hydraulisch gehärtete anorganische Zementzusammensetzung ist praktisch wasserunlöslich, d.h. im Wesentlichen oder vollständig wasserunlöslich.

Der hierin verwendete Begriff "elektronische Komponente" umfasst neben passiven elektronischen Bauteilen insbesondere Halbleitermodule und unter letzteren insbesondere elektronische Baugruppen.

Unter Halbleitermodulen werden hierin elektronische Baugruppen umfassend mindestens ein Substrat (als Schaltungsträger), mindestens einen Halbleiterbaustein (Halbleiter) sowie gegebenenfalls mindestens ein passives elektronisches Bauteil verstanden. Der mindestens eine Halbleiterbaustein kann dabei selber schon teilweise oder vollständig vorumhüllt sein, beispielsweise mit einer Ummantelung auf Epoxidharzbasis.

Hierin wird der Begriff "elektronische Baugruppe" verwendet. Eine elektronische Baugruppe im Sinne der vorliegenden Erfindung umfasst mindestens ein Substrat und mindestens ein damit mechanisch und elektrisch verbundenes elektronisches Bauteil. Die mechanische und elektrische Verbindung kann eine elektrisch leitfähige Lot-, Sinter- und/oder Klebeverbindung sein. Ferner kann eine solche elektronische Baugruppe einer elektrischen Verbindung dienende Elemente wie Bondbändchen, Bonddrähte, Clips, Abstandshalter und/oder Folien umfassen. Beispiele für elektronische Baugruppen in Rahmen- oder rahmenloser Bauweise umfassen diskrete Bauteile wie sogenannte power discretes, Leistungsmodule, Spannungswandler und bestimmte Sensoren.

Beispiele für Substrate umfassen IMS-Substrate (insulated metal-Substrate, isolierte Metallsubstrate), Metallkeramiksubstrate wie z.B. AMB-Substrate (active metal brazed-Substrate) und DCB-Substrate (direct copper bonded-Substrate), Keramiksubstrate, PCBs (printed circuit boards, gedruckte Leiterplatten) und Leadframes.

Elektronische Bauteile können eingeteilt werden in aktive und passive elektronische Bauteile.

Beispiele für aktive elektronische Bauteile umfassen Dioden, LEDs (light emitting diodes, Leuchtdioden), Dies (Halbleiterchips), IGBTs (insulated-gate bipolar transistors, Bipolartransistoren mit isolierter Gate-Elektrode), ICs (integrated circuits, integrierte Schaltungen) und MOSFETs (metal-oxide-semiconductor field-effect transistors, Metall-Oxid-Halbleiter-Feldeffekttransistoren).

Beispiele für passive elektronische Bauteile umfassen Bodenplatten, Kühlkörper, Verbindungselemente, Widerstände, Kondensatoren, Induktoren, Antennen Transformatoren, Drosseln, Spulen und keine elektronischen Baugruppen darstellende Sensoren.

Aufgabe der Erfindung war die Bereitstellung einer anorganische Fasern umfassenden hydraulisch härtbaren anorganischen Zementzusammensetzung, aus der wässrige Zement-Umhüllungsmassen zur Herstellung von Umhüllungen elektronischer Komponenten hergestellt werden können. Neben mittels der anorganischen Fasern verringerter Tendenz zur Rissbildung sollen sich die Umhüllungen durch eine hohe elektrische Isolationswirkung auszeichnen.

Anorganische Fasern oder Glasfasern umfassende hydraulisch härtbare anorganische Zementzusammensetzungen sind beispielsweise in EP 1 044 942 A1, WO 2015/067441 A1 und WO 2015/193035 A1 offenbart.

Es hat sich gezeigt, dass die Aufgabe gelöst werden kann durch Bereitstellung einer hydraulisch härtbaren anorganischen Zementzusammensetzung umfassend zerkleinerte unbeschichtete Glasfasern aus Alkalioxid-armem oder -freiem Glas und/oder zerkleinerte unbeschichtete Keramikfasern aus Alkalioxid-armer oder -freier Keramik.

Der hierin verwendete Ausdruck "Alkalioxid" steht insbesondere für die im Bereich von Glas üblichen Alkalimetalloxide Lithiumoxid, Natriumoxid bzw. Kaliumoxid.

Bei den zerkleinerten unbeschichteten Glasfasern aus Alkalioxid-armem oder -freiem Glas handelt es sich insbesondere um solche aus Glas umfassend <5 Gew.-%, bevorzugt <2 Gew.%, besonders bevorzugt <1 Gew.-% Alkalioxid.

Es ist erfindungswesentlich, dass das Glas der zerkleinerten unbeschichteten Glasfasern Alkalioxid-arm oder -frei ist, insbesondere <5 Gew.-%, bevorzugt <2 Gew.-%, besonders bevorzugt <1 Gew.-% Alkalioxid umfasst. Es kann sich um Quarzglasfasern handeln. Bevorzugt handelt es sich um Fasern aus Borosilikatglas, Alumosilikatglas respektive Aluminiumborsilikatglas jeweils mit entsprechend niedrigem oder keinem Gehalt an Alkalioxid.

Es ist ferner erfindungswesentlich, dass die Glasfasern unbeschichtet sind.

Die zerkleinerten unbeschichteten Glasfasern können eine anzahlgemittelte Faserlänge beispielsweise im Bereich von 20 bis 1000 µm, bevorzugt 40 bis 600 µm, insbesondere 40 bis 300 µm, jeweils bei einem Durchmesser beispielsweise im Bereich von 5 bis 50 µm, bevorzugt 10 bis 20 µm aufweisen.

Hierin wird mehrfach die anzahlgemittelte Faserlänge erwähnt. Diese kann beispielsweise mittels des FASEP^{®} ECO Systems von IDM Systems, Helga Mayr, 64297 Darmstadt bestimmt werden.

Die zerkleinerten unbeschichteten Glasfasern können durch Mahlen entsprechender zerschnittener oder zerhackter Glasfaserstränge hergestellt werden und sind kommerziell erhältlich.

Bei den zerkleinerten unbeschichteten Keramikfasern aus Alkalioxid-armer oder -freier Keramik handelt es sich insbesondere um solche aus Keramik mit einem Reinheitsgrad >98 Gew.-%.

Es ist erfindungswesentlich, dass die Keramik der zerkleinerten unbeschichteten Keramikfasern einen Reinheitsgrad >98 Gew.-% aufweist.

Es ist ferner erfindungswesentlich, dass die Keramikfasern unbeschichtet sind,

Bei den zerkleinerten unbeschichteten Keramikfasern handelt es sich insbesondere um solche, die ausgewählt sind aus der Gruppe bestehend aus jeweils einen Reinheitsgrad von >98 Gew.% aufweisenden Aluminiumoxidkeramikfasern, Aluminiumnitridkeramikfasern, Siliziumnitridkeramikfasern, Siliziumdioxidkeramikfasern, Siliziumcarbidkeramikfasern und Bornitridkeramikfasern.

Die zerkleinerten unbeschichteten Keramikfasern können eine anzahlgemittelte Faserlänge beispielsweise im Bereich von 20 bis 1000 µm, bevorzugt 40 bis 600 µm, insbesondere 40 bis 300 µm, jeweils bei einem Durchmesser beispielsweise im Bereich von 5 bis 50 µm, bevorzugt 10 bis 20 µm aufweisen.

Die zerkleinerten unbeschichteten Keramikfasern können durch Mahlen entsprechender zerschnittener oder zerhackter Keramikfaserstränge hergestellt werden und sind kommerziell erhältlich.

Die erfindungsgemäße hydraulisch härtbare anorganische Zementzusammensetzung umfasst insbesondere 5 bis 15 Gew.-%, bevorzugt 3 bis 8 Gew.-% zerkleinerte unbeschichtete Glasfasern aus Glas mit einem Anteil von <5 Gew.-%, bevorzugt <2 Gew.-%, besonders bevorzugt <1 Gew.-% Alkalioxid und/oder zerkleinerte unbeschichtete Keramikfasern ausgewählt aus der Gruppe bestehend aus jeweils einen Reinheitsgrad von >98 Gew.-% aufweisenden Aluminiumoxidkeramikfasern, Aluminiumnitridkeramikfasern, Siliziumnitridkeramikfasern, Siliziumdioxidkeramikfasern, Siliziumcarbidkeramikfasern und Bornitridkeramikfasern. Bevorzugt umfasst die hydraulisch härtbare anorganische Zementzusammensetzung Glasfasern besagten Typs, und letztere insbesondere alleine, d.h. ohne gleichzeitige Anwesenheit von Keramikfasern besagten Typs.

Die erfindungsgemäße als Pulver (in Pulverform) vorliegende hydraulisch härtbare anorganische Zementzusammensetzung kann durch Vermischen mit Wasser in eine wässrige hydraulisch härtbare als Umhüllungsmasse verwendbare Zubereitung überführt werden. Die wässrige Umhüllungsmasse kann zur Herstellung einer hydraulisch gehärteten Umhüllung einer elektronischen Komponente verwendet werden.

Die erfindungsgemäße hydraulisch härtbare anorganischen Zementzusammensetzung umfasst neben besagten Glasfasern und/oder besagten Keramikfasern, möglichem nichtfaserförmigem partikelförmigem Füllstoff und möglichen weiteren Bestandteilen einen hydraulisch härtbaren anorganischen Zement. Er ist ein Pulver. Die Zementpulverteilchen können beispielsweise absolute Teilchengrößen im Bereich von bis zu 1 mm aufweisen. Es kann sich bei dem hydraulisch härtbaren anorganischen Zement beispielsweise um einen dem Fachmann bekannten Portlandzement, Tonerdezement, Magnesiumoxidzement oder Phosphatzement handeln. Bevorzugt ist ein Phosphatzement, beispielsweise Zinkphosphatzement oder insbesondere Magnesiumphosphatzement. Der hydraulisch härtbare anorganische Zement kann beispielsweise 2 bis 95 Gew.-%, bevorzugt 3 bis 40 Gew.-% der erfindungsgemäßen hydraulisch härtbaren anorganischen Zementzusammensetzung ausmachen.

Die erfindungsgemäße hydraulisch härtbare anorganische Zementzusammensetzung kann insbesondere aus folgenden Bestandteilen zusammengesetzt sein:
(a) 2 bis 95, bevorzugt 3 bis 40 Gew.-% eines Zements ausgewählt aus der Gruppe bestehend aus Portlandzement, Tonerdezement, Magnesiumoxidzement und Phosphatzement,
(b) 5 bis 15 Gew.-%, bevorzugt 3 bis 8 Gew.-% zerkleinerte unbeschichtete Glasfasern aus Glas mit einem Anteil von <5 Gew.-%, bevorzugt <2 Gew.-%, besonders bevorzugt <1 Gew.-% Alkalioxid und/oder zerkleinerte unbeschichtete Keramikfasern ausgewählt aus der Gruppe bestehend aus jeweils einen Reinheitsgrad von >98 Gew.-% aufweisenden Aluminiumoxidkeramikfasern, Aluminiumnitridkeramikfasern, Siliziumnitridkeramikfasern, Siliziumdioxidkeramikfasern, Siliziumcarbidkeramikfasern und Bornitridkeramikfasern,
(c) 0 bis 90 Gew.-%, bevorzugt 40 bis 80 Gew.-% mindestens eines nichtfaserförmigen partikelförmigen Füllstoffs,
(d) 0 bis 30 Gew.-%, bevorzugt 2 bis 15 Gew.-% mindestens eines von den Bestandteilen (a) bis (c) verschiedenen Bestandteils. Die Bestandteile (a) bis (d) addieren sich dabei zu 100 Gew.-% erfindungsgemäßer hydraulisch härtbarer anorganischer Zementzusammensetzung; mit anderen Worten, die erfindungsgemäße hydraulisch härtbare anorganische Zementzusammensetzung kann aus den Bestandteilen (a) und (b) oder aus den Bestandteilen(a), (b) und (c) oder aus den Bestandteilen(a), (b) und (d) oder aus den Bestandteilen (a), (b), (c) und (d) bestehen.

Bestandteil (a) ist ein hydraulisch härtbarer anorganischer Zement. Er ist ein Pulver. Die Zementpulverteilchen können beispielsweise absolute Teilchengrößen im Bereich von bis zu 1 mm aufweisen. Der hydraulisch härtbare anorganische Zement ist ausgewählt aus der Gruppe bestehend aus Portlandzement, Tonerdezement, Magnesiumoxidzement und Phosphatzement. Bevorzugt handelt es sich bei Bestandteil (a) um einen Phosphatzement, beispielsweise Zinkphosphatzement oder insbesondere Magnesiumphosphatzement.

Der als Bestandteil (a) insbesondere bevorzugte Phosphatzement kann sich zusammensetzen aus:
(a1) 10 bis 90 Gew.-%, bevorzugt 30 bis 60 Gew.-% mindestens eines Hydrogenphosphats ausgewählt aus der Gruppe bestehend aus Mono- und Dihydrogenphosphaten von Magnesium, Calcium und Aluminium, und
(a2) 90 bis 10 Gew.-%, bevorzugt 70 bis 40 Gew.-% mindestens einer Verbindung ausgewählt aus der Gruppe bestehend aus Oxiden, Hydroxiden und Oxidhydraten von Magnesium, Calcium, Eisen, Zink, Zirkonium, Lanthan und Kupfer. Die Summe der Gewichts-% der Bestandteile (a1) und (a2) ergibt dabei 100 Gew.-% Bestandteil (a).

Bei Bestandteil (a1) handelt es sich um mindestens eine Substanz ausgewählt aus der Gruppe bestehend aus Magnesiummonohydrogenphosphat, Calciummonohydrogenphosphat, Aluminiummonohydrogenphosphat, Magnesiumdihydrogenphosphat, Calciumdihydrogenphosphat und Aluminiumdihydrogenphosphat. Mit anderen Worten, es handelt sich um mindestens ein Hydrogenphosphat ausgewählt aus der Gruppe bestehend aus Mono- und Dihydrogenphosphaten von Magnesium, Calcium, Aluminium. Insbesondere handelt es sich um mindestens ein Hydrogenphosphat ausgewählt aus der Gruppe bestehend aus Mono- und Dihydrogenphosphaten von Magnesium und Aluminium.

Bestandteil (a1) ist ein Pulver mit absoluten Teilchengrößen beispielsweise im Bereich von bis zu 1 mm.

Bei Bestandteil (a2) handelt es sich um mindestens eine Verbindung ausgewählt aus der Gruppe bestehend aus Oxiden, Hydroxiden und Oxidhydraten von Magnesium, Calcium, Eisen, Zink, Zirkonium, Lanthan und Kupfer, insbesondere um mindestens eine Verbindung ausgewählt aus der Gruppe bestehend aus Magnesiumoxid, Magnesiumhydroxid, Zirkoniumoxid, Zirkoniumoxidhydrat und Zirkoniumhydroxid. Magnesiumoxid ist besonders bevorzugt.

Bestandteil (a2) ist ein Pulver beispielsweise mit absoluten Teilchengrößen im Bereich von bis zu 1 mm.

Um unnötige Längen zu vermeiden, wird bezüglich Bestandteil (b) auf das Vorerwähnte Bezug genommen.

Beim optionalen, bevorzugt jedoch vorhandenen Bestandteil (c) handelt es sich um mindestens einen nichtfaserförmigen partikelförmigen Füllstoff, der insbesondere ausgewählt sein kann aus der Gruppe bestehend aus Mono-, Oligo- und Polyphosphaten von Magnesium, Calcium, Barium und Aluminium; Calciumsulfat; Bariumsulfat; einfachen und komplexen Silikaten umfassend Calcium, Aluminium, Magnesium, Eisen und/oder Zirkonium; einfachen und komplexen Aluminaten umfassend Calcium, Magnesium und/oder Zirkonium; einfachen und komplexen Titanaten umfassend Calcium, Aluminium, Magnesium, Barium und/oder Zirkonium; einfachen und komplexen Zirkonaten umfassend Calcium, Aluminium und/oder Magnesium; Zirkoniumdioxid; Titandioxid; Aluminiumoxid; Siliziumdioxid, insbesondere in Form von Kieselsäure und Quarz; Siliziumcarbid; Aluminiumnitrid; Bornitrid und Siliziumnitrid. Hierin wird zwischen einfachen und komplexen Silikaten, Aluminaten, Titanaten und Zirkonaten unterschieden. Bei den komplexen Vertretern handelt es sich nicht etwa um Komplexverbindungen, vielmehr sind damit Silikate, Aluminate, Titanate und Zirkonate gemeint mit mehr als einer Art von Kationen, wie beispielsweise Calciumaluminiumsilikat, Bleizirkontitanat usw.

Bestandteil (c) ist ein Pulver beispielsweise mit absoluten Teilchengrößen im Bereich von bis zu 1 mm.

Beim optionalen Bestandteil (d) handelt es sich um einen oder mehrere jeweils von den Bestandteilen (a) bis (c) verschiedene Bestandteile wie beispielsweise Fließverbesserer, Abbindeverzögerer (Topfzeitverlängerer), Entschäumer, Hydrophobisierungsmittel, Oberflächenspannung beeinflussende Additive, Benetzungsmittel und Haftvermittler.

Die erfindungsgemäße und insbesondere aus den Bestandteilen (a), (b), bevorzugt auch (c) und gegebenenfalls (d) bestehende hydraulisch härtbare anorganische Zementzusammensetzung kann als einkomponentige pulverförmige Zusammensetzung oder in Form zweier oder mehrerer jeweils pulverförmiger Komponenten, d.h. voneinander verschiedener und separater Komponenten (separat zu lagernder bzw. separat gelagerter Komponenten) vorliegen. Im Falle einer zwei- oder mehrkomponentigen Zusammensetzung, umfassen die Komponenten zusammen alle Bestandteile, d.h. im Besonderen die Bestandteile (a) und (b); respektive (a) bis (c); (a) bis (d); oder (a), (b) und (d). Die zwei oder mehreren Komponenten werden separat voneinander gelagert bis zu ihrer Verwendung zur Herstellung einer wässrigen hydraulisch härtbaren anorganischen Zementzubereitung; dabei kann es insbesondere zweckmäßig sein, eine zumindest im Wesentlichen voneinander separate Lagerung von Bestandteilen (a1) und (a2) zu verwirklichen.

Aus einer erfindungsgemäßen hydraulisch härtbaren anorganischen Zementzusammensetzung, welche in ein-, zwei- oder mehrkomponentiger Pulverform vorliegen kann, kann durch Vermischen mit Wasser eine wässrige hydraulisch härtbare anorganische Zementzubereitung hergestellt werden. Im Falle eines Zwei- oder Mehrkomponentensystems können zunächst die Komponenten zu einer einkomponentigen hydraulisch härtbaren anorganischen Zementzusammensetzung vermischt und diese dann mit Wasser vermischt werden. Es ist aber auch möglich nur eine, einige oder alle Komponenten zunächst mit Wasser zu vermischen, beispielsweise zu Pasten; danach kann ein weiteres Vermischen unter Bildung der wässrigen hydraulisch härtbaren anorganischen Zementzubereitung erfolgen. Eine derartige wässrige hydraulisch härtbare anorganische Zementzubereitung kann zur Herstellung einer hydraulisch gehärteten anorganischen Zementzusammensetzung insbesondere in Form einer Umhüllung einer elektronischen Komponente verwendet werden; sie kann nach ihrer Applikation hydraulisch zu einer hydraulisch gehärteten anorganischen Zementzusammensetzung in Form eines harten Festkörpers aushärten und trocknen. Besagter harter Festkörper kann insbesondere besagte Umhüllung einer elektronischen Komponente sein.

Eine aus einer erfindungsgemäßen hydraulisch härtbaren anorganischen Zementzusammensetzung durch Vermischen mit Wasser erhältliche wässrige hydraulisch härtbare anorganische Zementzubereitung kann einen Wasseranteil von beispielsweise 6 bis 25 Gew.-% aufweisen.

Die Viskosität einer frisch hergestellten (innerhalb von 5 Minuten nach Fertigstellung) wässrigen hydraulisch härtbaren anorganischen Zementzubereitung kann beispielsweise im Bereich von 0,5 bis 20 Pa·s (bei Bestimmung mittels Rotationsviskosimetrie, Platte-Platte-Messprinzip, Plattendurchmesser 25 mm, Messspalt 1 mm, Probentemperatur 20°C) liegen.

Wie gesagt, die wässrige hydraulisch härtbare anorganische Zementzubereitung kann als wässrige Umhüllungsmasse für elektronische Komponenten verwendet werden. Der Kürze halber wird in der weiteren Folge auch der Begriff "wässrige Umhüllungsmasse" anstelle von "wässrige hydraulisch härtbare anorganische Zementzubereitung" verwendet.

Die wässrige Umhüllungsmasse kann zur Herstellung einer hydraulisch gehärteten Umhüllung von elektronischen Komponenten verwendet werden. Das Herstellungsverfahren umfasst die Schritte:
(1) Bereitstellen einer zu umhüllenden elektronischen Komponente,
(2) Bereitstellen einer durch Vermischen einer erfindungsgemäßen wässrigen hydraulisch härtbaren anorganischen Zementzusammensetzung mit Wasser hergestellten wässrigen Umhüllungsmasse,
(3) Umhüllen der in Schritt (1) bereitgestellten elektronischen Komponente mit der in Schritt (2) bereitgestellten wässrigen Umhüllungsmasse, und
(4) hydraulisches Härten der wässrigen die elektronische Komponente nach Beendigung von Schritt (3) umhüllenden Umhüllungsmasse.

In Schritt (1) wird eine zu umhüllende elektronische Komponente bereitgestellt. Bezüglich des Begriffs "elektronische Komponente" wird auf das Vorerwähnte verwiesen.

Bezüglich Schritt (2) wird auf das Vorerwähnte verwiesen.

Bevorzugt wird Schritt (3) unverzüglich, beispielsweise innerhalb von 60 Minuten, bevorzugt innerhalb von 10 Minuten nach Beendigung von Schritt (2) respektive nach Beendigung der Herstellung der wässrigen Umhüllungsmasse durchgeführt.

In Schritt (3) erfolgt das Umhüllen der in Schritt (1) bereitgestellten elektronischen Komponente mit der gemäß Schritt (2) bereitgestellten wässrigen Umhüllungsmasse. Bevorzugte Applikationsmethoden sind Vergießen, Tauchen und Spritzgießen (englisch: transfer molding). Das Vergießen kann mittels üblichen, dem Fachmann bekannten Methoden erfolgen, beispielsweise durch Schwerkraft-, vakuum- oder druckunterstützten Verguss (englisch: compression molding). Dabei kann es zweckmäßig sein, die zu umhüllende elektronische Komponente mit Halbschalenformen zu umschließen und dann mit der wässrigen Umhüllungsmasse zu füllen. Das Umhüllen kann als teilweises oder vollständiges Umhüllen erfolgen. Beispielsweise kann bei der Umhüllung eines Halbleitermoduls so gearbeitet werden, dass die Umhüllungsmasse mit dem Halbleiterbaustein verbundene elektrische Kontaktierungselemente wie beispielsweise Bonddrähte, Bändchen und/oder ein Substrat teilweise oder vollständig umhüllt. Teilweise Umhüllung bedeutet dabei, dass ein oder mehrere der Kontaktierungselemente unvollständig und/oder ein oder mehrere der Kontaktierungselemente nicht umhüllt sind, während vollständige Umhüllung bedeutet, dass alle Kontaktierungselemente vollständig umhüllt sind. Das Vergießen kann aber beispielsweise auch so erfolgen, dass die Umhüllungsmasse als dem Fachmann bekanntes "glob-top" ausgebildet wird.

Im auf Schritt (3) folgenden Schritt (4) wird die wässrige, die elektronische Komponente umhüllende Umhüllungsmasse hydraulisch gehärtet. Selbstverständlich hat das hydraulische Härten schon ab dem Moment begonnen, in dem die wässrige Umhüllungsmasse hergestellt worden ist, d.h. schon im Zuge von respektive nach Abschluss von Schritt (2).

Das hydraulische Härten kann bei Umgebungsbedingungen, beispielsweise bei einer Umgebungstemperatur im Bereich von 20 bis 25 °C stattfinden und dabei beispielsweise eine Dauer von 1 Minute bis 6 Stunden benötigen. Soll die Dauer verkürzt werden, kann bei erhöhter Temperatur gearbeitet werden, beispielsweise kann das hydraulische Härten bei 30 bis unter 100 °C Objekttemperatur stattfinden und es ist dann schon beispielsweise innerhalb weniger Sekunden bis 1 Stunde beendet.

Ans hydraulische Härten schließt sich ein Trocknen der Umhüllung an im Sinne einer Entfernung von chemisch nicht gebundenem Wasser aus der hydraulisch gehärteten anorganischen Zementzusammensetzung. Dies kann im weiteren zeitlichen Verlauf geschehen; zweckmäßig allerdings kann auch ein der Entwässerung dienendes forciertes Trocknen ans hydraulische Härten angeschlossen werden, beispielsweise für 0,5 bis 6 Stunden bei 80 bis 300 °C Objekttemperatur; dabei kann es zweckmäßig sein, mehrere Temperaturstufen zu durchlaufen. Das Trocknen kann vakuumunterstützt erfolgen.

### Beispiele

### A) Herstellung wässriger hydraulisch härtbarer anorganischer Zementzubereitungen

Erfindungsgemäßes Beispiel 1: 7 Gewichtsanteile Magnesiumoxidpulver, 2 Gewichtsanteile Magnesiumdihydrogenphosphatpulver, 4 Gewichtsanteile 2-Imidazolidinon, 6 Gewichtsanteile unbeschichtete Aluminiumborsilikat-Glasfasern mit weniger als 2 Gew.-% Alkalioxid, mit einer anzahlgemittelten Faserlänge von 50 µm und einem Durchmesser von 15 µm, 66 Gewichtsanteile Zirkoniumsilikat mit einer maximalen Teilchengröße von 100 µm und 15 Gewichtsanteile Wasser wurden zu einer wässrigen Zementzubereitung vermischt.

Erfindungsgemäßes Beispiel 2: Es wurde wie in Beispiel 1 gearbeitet, jedoch wurden unbeschichtete Aluminiumborsilikat-Glasfasern mit weniger als 2 Gew.-% Alkalioxid, mit einer anzahlgemittelten Faserlänge von 190 µm und einem Durchmesser von 15 µm verwendet.

Vergleichsbeispiel 3: Es wurde wie in Beispiel 1 gearbeitet, jedoch wurden auf Basis von Silan beschichtete Aluminiumborsilikat-Glasfasern mit einer anzahlgemittelten Faserlänge von 210 µm und einem Durchmesser von 15 µm verwendet.

### B) Bewertung der elektrischen Isolationseigenschaften von aus den wässrigen hydraulisch härtbaren anorganischen Zementzubereitungen gemäß Beispielen 1 bis 3 hergestellten hydraulisch gehärteten anorganischen Zementzusammensetzungen

Für die Bewertung der elektrischen Isolationseigenschaften der hydraulisch gehärteten anorganischen Zementzusammensetzungen wurden zunächst je 5 Testzellen aufgebaut. Hierzu wurden in jeweils fünf runde Aluminiumschalen (Durchmesser 55 mm, Randhöhe 15 mm) mit doppelseitigem Kupferklebeband (Länge x Breite x Dicke: 27 ± 1 mm x 21 ± 1 mm x 0,12 mm) jeweils mittig ein doppelseitig metallisiertes Kupfer-Aluminiumoxidkeramik-Substrat (DCB, Fläche 27 x 38 mm, Dicke der Kupfermetallisierung jeweils 0,3 mm, Dicke der Aluminiumoxidkeramik: 0,38 mm, umlaufender nicht-metallisierter Aluminiumoxidrand von 0,5 mm) geklebt. Ein weiteres Kupferklebeband (Länge x Breite x Dicke: 50 mm x 12 mm x 0,11 mm) wurde L-förmig auf die oberseitige Kupferfolie des jeweiligen DCB-Substrates geklebt (Länge des aufgeklebten Teils 10 mm, Länge des abgeknickten Teils 40 mm).

Anschließend wurden in die so ausgestatteten Aluminiumschalen je 18 ± 0,2 g der wässrigen hydraulisch härtbaren anorganischen Zementzubereitungen der Beispiele 1 bis 3 eingewogen. Dabei wurde sichergestellt, dass die jeweilige Zementzubereitung das jeweilige DCB-Substrat vollständig bedeckte und bis zum Rand der Aluminiumschale geflossen war. Der abgeknickte Teil des auf der Oberfläche des DCB-Substrats befestigten Kupferklebebands ragte dabei aus der Zementzubereitung senkrecht heraus.

Anschließend wurden die Testzellen zwecks hydraulischer Aushärtung der jeweiligen Zementzubereitung zunächst für 2 Stunden bei 20°C belassen, gefolgt von einer Temperaturbehandlung in einem Laborofen; hierzu wurde die Ofentemperatur mit einer Heizrate von 1°C/min ausgehend von 20°C auf 90°C erhöht und für 1 Stunde auf 90°C gehalten. Anschließend wurde die Ofentemperatur mit einer Heizrate von 1°C/min auf 160°C erhöht und für 1 Stunde auf 160°C gehalten. Danach wurde mit einer Abkühlrate von 1°C/min auf 20°C abgekühlt.

Zur Bestimmung der elektrischen Isolationseigenschaften wurde eine Messung der sogenannten Durchschlagfestigkeit an den je 5 Testzellen mit einem Messgerät TPS 652-714 der Firma Schuster Elektronik GmbH durchgeführt. Hierzu wurde mit Hilfe des Messgeräts eine Gleichspannung zwischen der Aluminiumschale, welche über das Kupferklebeband mit der unterseitigen Kupferfolie des DCB-Substrats verbunden war, und dem aus der Zementzusammensetzung herausragenden Kupferklebeband, welches an der oberseitigen Kupferfolie des DCB-Substrats befestigt war, angelegt. Zunächst wurden 100 V für 1 s angelegt, die entsprechend der in Tabelle 1 angegebenen Weise stufenweise bis auf 4000 V erhöht wurde. Sobald ein Verluststrom von ≥ 2 mA registriert wurde, wurde dies als Durchschlag interpretiert und der Versuch beendet. Für die Testzellen, welche mit den erfindungsgemäßen Zementzubereitungen gemäß Beispiel 1 und Beispiel 2 vergossen wurden, konnte die Spannung bis auf 4000 V erhöht werden, ohne dass ein Verluststrom registriert wurde. Folglich wiesen diese Zementzusammensetzungen eine gute elektrische Isolationseigenschaft respektive einen hohen elektrischen Widerstand auf. Hingegen wurde bei Testzellen, vergossen mit der Zementzubereitung gemäß Vergleichsbeispiel 3, ein Verluststrom von >2 mA bereits bei einer Spannung von 1200 V detektiert.

**Tabelle 1: Spannungsmessprofil zur Bestimmung der Durchschlagsspannung.**

| Messpunkt | Spannung [V] | Zeit [s] | Ergebnis |
|---|---|---|---|
| 1 | 100 | 1 | |
| 2 | 1000 | 1 | |
| 3 | 1200 | 1 | Durchschlag bei Beispiel 3 |
| 4 | 1500 | 1 | |
| 5 | 1700 | 1 | |
| 6 | 2000 | 1 | |
| 7 | 2200 | 1 | |
| 8 | 2500 | 1 | |
| 9 | 2700 | 1 | |
| 10 | 3000 | 1 | |
| 11 | 3200 | 1 | |
| 12 | 3500 | 1 | |
| 13 | 3700 | 1 | |
| 14 | 4000 | 1 | Kein Durchschlag bei Beispielen 1 und 2 |

## Patentansprüche

1. Hydraulisch härtbare anorganische Zementzusammensetzung umfassend zerkleinerte unbeschichtete Glasfasern aus Alkalioxid-armem oder -freiem Glas und/oder zerkleinerte unbeschichtete Keramikfasern aus Alkalioxid-armer oder -freier Keramik.

2. Hydraulisch härtbare anorganische Zementzusammensetzung nach Anspruch 1 umfassend 5 bis 15 Gew.-% zerkleinerte unbeschichtete Glasfasern aus Glas mit einem Anteil von <5 Gew.-% Alkalioxid und/oder zerkleinerte unbeschichtete Keramikfasern ausgewählt aus der Gruppe bestehend aus jeweils einen Reinheitsgrad von >98 Gew.-% aufweisenden Aluminiumoxidkeramikfasern, Aluminiumnitridkeramikfasern, Siliziumnitridkeramikfasern, Siliziumdioxidkeramikfasern, Siliziumcarbidkeramikfasern und Bornitridkeramikfasern.

3. Hydraulisch härtbare anorganische Zementzusammensetzung nach Anspruch 1 oder 2, umfassend einen hydraulisch härtbaren anorganischen Zement neben den Glasfasern und/oder Keramikfasern, möglichem nichtfaserförmigem partikelförmigem Füllstoff und möglichen weiteren Bestandteilen.

4. Hydraulisch härtbare anorganische Zementzusammensetzung nach Anspruch 3, wobei der hydraulisch härtbare anorganische Zement ein Portlandzement, Tonerdezement, Magnesiumoxidzement oder Phosphatzement ist.

5. Hydraulisch härtbare anorganische Zementzusammensetzung nach Anspruch 3 oder 4, wobei der hydraulisch härtbare anorganische Zement 2 bis 95 Gew.-% der hydraulisch härtbaren anorganischen Zementzusammensetzung ausmacht.

6. Hydraulisch härtbare anorganische Zementzusammensetzung zusammengesetzt aus:
(a) 2 bis 95 Gew.-% eines Zements ausgewählt aus der Gruppe bestehend aus Portlandzement, Tonerdezement, Magnesiumoxidzement und Phosphatzement,
(b) 5 bis 15 Gew.-% zerkleinerte unbeschichtete Glasfasern aus Glas mit einem Anteil von <5 Gew.-% Alkalioxid und/oder zerkleinerte unbeschichtete Keramikfasern ausgewählt aus der Gruppe bestehend aus jeweils einen Reinheitsgrad von >98 Gew.-% aufweisenden Aluminiumoxidkeramikfasern, Aluminiumnitridkeramikfasern, Siliziumnitridkeramikfasern, Siliziumdioxidkeramikfasern, Siliziumcarbidkeramikfasern und Bornitridkeramikfasern,
(c) 0 bis 90 Gew.-% mindestens eines nichtfaserförmigen partikelförmigen Füllstoffs,
(d) 0 bis 30 Gew.-% mindestens eines von den Bestandteilen (a) bis (c) verschiedenen Bestandteils,
wobei sich die Bestandteile (a) bis (d) zu 100 Gew.-% addieren.

7. Hydraulisch härtbare anorganische Zementzusammensetzung nach Anspruch 6, wobei Bestandteil (a) ein Phosphatzement ist, zusammengesetzt aus:
(a1) 10 bis 90 Gew.-% mindestens eines Hydrogenphosphats ausgewählt aus der Gruppe bestehend aus Mono- und Dihydrogenphosphaten von Magnesium, Calcium und Aluminium, und
(a2) 90 bis 10 Gew.-% mindestens einer Verbindung ausgewählt aus der Gruppe bestehend aus Oxiden, Hydroxiden und Oxidhydraten von Magnesium, Calcium, Eisen, Zink, Zirkonium, Lanthan und Kupfer,
wobei die Summe der Gewichts-% der Bestandteile (a1) und (a2) 100 Gew.-% ergibt.

8. Hydraulisch härtbare anorganische Zementzusammensetzung nach einem der vorhergehenden Ansprüche, wobei die zerkleinerten unbeschichteten Glasfasern eine anzahlgemittelte Faserlänge im Bereich von 20 bis 1000 µm bei einem Durchmesser im Bereich von 5 bis 50 µm aufweisen.

9. Hydraulisch härtbare anorganische Zementzusammensetzung nach einem der vorhergehenden Ansprüche, wobei die zerkleinerten unbeschichteten Glasfasern ausgewählt sind aus der Gruppe bestehend aus Quarzglasfasern, Borosilikatglasfasern, Alumosilikatglasfasern und Aluminiumborsilikatglasfasern.

10. Hydraulisch härtbare anorganische Zementzusammensetzung nach einem der vorhergehenden Ansprüche, wobei die zerkleinerten unbeschichteten Keramikfasern eine anzahlgemittelte Faserlänge im Bereich von 20 bis 1000 µm bei einem Durchmesser im Bereich von 5 bis 50 µm aufweisen.

11. Hydraulisch härtbare anorganische Zementzusammensetzung nach einem der vorhergehenden Ansprüche als einkomponentige pulverförmige Zusammensetzung oder in Form zweier oder mehrerer jeweils pulverförmiger voneinander verschiedener und separater Komponenten.

12. Wässrige hydraulisch härtbare anorganische Zementzubereitung hergestellt durch Vermischen einer hydraulisch härtbaren anorganischen Zementzusammensetzung nach einem der vorhergehenden Ansprüche mit Wasser.

13. Verwendung einer wässrigen hydraulisch härtbaren anorganischen Zementzubereitung nach Anspruch 12 zur Herstellung einer hydraulisch gehärteten anorganischen Zementzusammensetzung in Form einer Umhüllung einer elektronischen Komponente.

14. Verfahren zur Herstellung einer hydraulisch gehärteten Umhüllung einer elektronischen Komponente, umfassend die Schritte:
(1) Bereitstellen einer zu umhüllenden elektronischen Komponente,
(2) Bereitstellen einer durch Vermischen einer hydraulisch härtbaren anorganischen Zementzusammensetzung nach einem der Ansprüche 1 bis 11 mit Wasser hergestellten wässrigen Umhüllungsmasse,
(3) Umhüllen der in Schritt (1) bereitgestellten elektronischen Komponente mit der in Schritt (2) bereitgestellten wässrigen Umhüllungsmasse, und
(4) hydraulisches Härten der wässrigen die elektronische Komponente nach Beendigung von Schritt (3) umhüllenden Umhüllungsmasse.
